# EUROPEAN PATENT APPLICATION

(11) **EP 4 800 740 A1**
(43) Date of publication of application: **02.09.2026**
(21) Application number: 24882090.4
(22) Date of filing: 25.09.2024
(51) Int. Cl.: H01L 21/318, C23C 16/455, H01L 21/31

(54) **SUBSTRATE PROCESSING METHOD, METHOD FOR PRODUCING SEMICONDUCTOR DEVICE, PROGRAM, AND SUBSTRATE PROCESSING DEVICE**

(30) Priority: 27.10.2023 JP 2023184760
(71) Applicant: Kokusai Electric Corporation, Tokyo 100-0004 (JP)
(72) Inventor: NOHARA, Shingo, Toyama-shi, Toyama 939-2393 (JP); ISHIBASHI, Kiyohisa, Toyama-shi, Toyama 939-2393 (JP); YAMANE, Yoma, Toyama-shi, Toyama 939-2393 (JP); SHIMURA, Jumpei, Toyama-shi, Toyama 939-2393 (JP)
(74) Representative: Bardehle Pagenberg Partnerschaft mbB Patentanwälte Rechtsanwälte
(86) International application number: PCT/JP2024/034283
(87) International publication number: WO 2025/088973

(57) **Abstract**

A method according to the present invention includes: (a) a step for setting the supply amount of a modifier on the basis of a relationship between the supply amount of the modifier and the characteristic of saturated adsorption of a raw material to a substrate; and (b) a step for supplying the modifier to the substrate on the basis of the set supply amount.

## Description

### TECHNICAL FIELD

The present disclosure relates to a method of processing a substrate, a method of manufacturing a semiconductor device, a program, and a substrate processing apparatus.

### BACKGROUND

As a process of manufacturing a semiconductor device, a substrate processing step may be performed in which a precursor gas and a reaction gas are supplied to a substrate to form a film on the substrate (for example, *see* Patent Document 1).

### [Prior Art Document]

### Patent Document

Patent Document 1: Japanese laid-open publication No. 2014-135475

### SUMMARY

The present disclosure provides a technique capable of improving properties of a film formed on a substrate.

According to some embodiments of the present disclosure, there is provided a technique that includes: (a) setting a supply amount of a modifying agent based on a relationship between the supply amount of the modifying agent and a saturated adsorption property of a precursor on the substrate; and (b) supplying the modifying agent to the substrate based on the set supply amount.

According to the present disclosure, it is possible to provide a technique capable of improving properties of a film formed on a substrate.

### BRIEF DESCRIPTION OF DRAWINGS

FIG. 1 is a vertical cross-sectional view schematically illustrating a vertical process furnace of a substrate processing apparatus 10 suitably used in some embodiments of the present disclosure.
FIG. 2 is a schematic configuration diagram of the vertical process furnace of the substrate processing apparatus 10 suitably used in some embodiments of the present disclosure, and illustrates a portion of the process furnace 202 in a cross-sectional view taken along line A-A of FIG. 1.
FIG. 3 is a schematic configuration diagram of a controller 121 of a substrate processing apparatus suitably used in some embodiments of the present disclosure, and illustrates a control system of the controller 121 in a block diagram.
FIG. 4 is a diagram illustrating an example of a processing sequence according to some embodiments of the present disclosure.
FIG. 5 is a diagram illustrating a relationship between a supply amount of a modifying agent and an adsorption property of a precursor according to some embodiments of the present disclosure.
FIG. 6 is a diagram illustrating a relationship between a supply amount of a modifying agent and a saturated adsorption amount of a precursor according to some embodiments of the present disclosure.

### DETAILED DESCRIPTION

### <Some Embodiments of Present Disclosure>

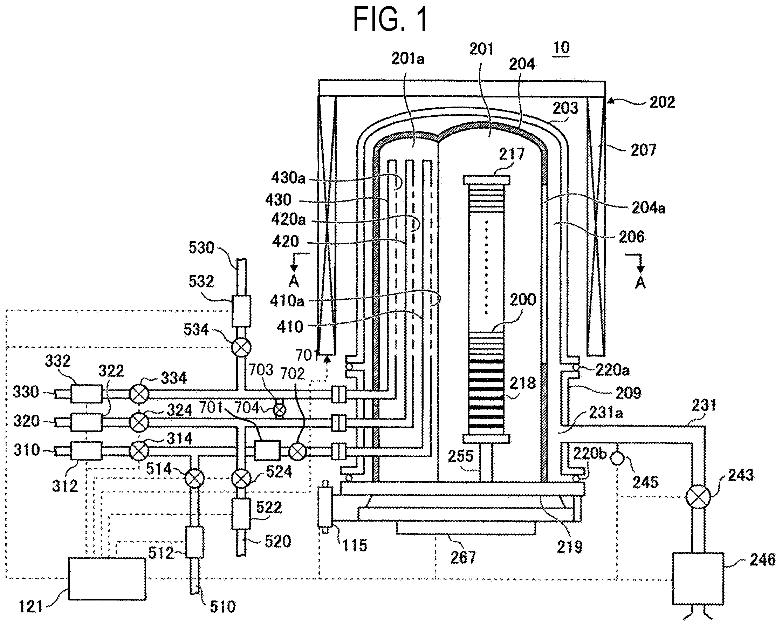

Hereinafter some embodiments of the present disclosure will be described with reference to FIGS. 1 to 6. Drawings used in the following description are schematic, and dimensional relationships, ratios, and the like of various elements shown in the drawings may not match actual ones. Further, dimensional relationships, ratios, and the like of various elements among plural figures may not match each other.

### (1) Configuration of Substrate Processing Apparatus

The substrate processing apparatus 10 includes a process furnace 202 provided with a heater 207 serving as a heating means or unit (heating mechanism, heating system). The heater 207 is formed in a cylindrical shape and is supported by a heater base (not illustrated) serving as a holding plate so as to be vertically installed.

An outer tube 203 is arranged inside the heater 207 to constitute a reaction tube (reaction container or process container) concentrically with the heater 207. The outer tube 203 is made of, for example, a heat-resistant material such as quartz or silicon carbide (SiC), and is formed in a cylindrical shape with its upper end closed and its lower end opened. A manifold 209 is arranged concentrically with the outer tube 203 below the outer tube 203. The manifold 209 is made of, for example, a metal such as stainless steel, and is formed in a cylindrical shape with its upper and lower ends opened. An O-ring 220a serving as a seal is installed between the upper end of the manifold 209 and the outer tube 203. With the manifold 209 supported by the heater base, the outer tube 203 is vertically installed.

An inner tube 204 is arranged inside the outer tube 203 to constitute the reaction container. The inner tube 204 is made of, for example, a heat-resistant material such as quartz or SiC, and is formed in a cylindrical shape with its upper end closed and its lower end opened. The process container (reaction container) is mainly constituted by the outer tube 203, the inner tube 204, and the manifold 209. A process chamber 201 is formed in a hollow cylindrical region of the process container (inside the inner tube 204).

The process chamber 201 is configured to be capable of accommodating wafers 200 as substrates in such a state that the wafers 200 are arranged in a horizontal posture and in multiple stages along a vertical direction by a boat 217 serving as a support.

Nozzles 410, 420, and 430 are installed in the process chamber 201 so as to penetrate a sidewall of the manifold 209 and the inner tube 204. Gas supply pipes 310, 320, and 330 are connected to the nozzles 410, 420, and 430, respectively. However, the process furnace 202 of the embodiments of the present disclosure is not limited to the above-described form.

At the gas supply pipes 310, 320, and 330, mass flow controllers (MFCs) 312, 322, and 332, which are flow rate controllers (flow rate control parts), are installed in this order from the upstream side, respectively. Further, at the gas supply pipes 310, 320, and 330, valves 314, 324, and 334, which are on-off valves are installed respectively. Gas supply pipes 510, 520, and 530 configured to supply an inert gas are connected to the gas supply pipes 310, 320, and 330 at the downstream side of the valves 314, 324, and 334, respectively. At the gas supply pipes 510, 520, and 530, MFCs 512, 522, and 532, which are flow rate controllers (flow rate control parts), and valves 514, 524, and 534, which are on-off valves, in this order from the upstream side are installed, respectively.

Nozzles 410, 420, and 430 are connected to tips of the gas supply pipes 310, 320, and 330, respectively. The nozzles 410, 420, and 430 are constituted as L-shaped nozzles, and horizontal portions thereof are installed so as to penetrate the sidewall of the manifold 209 and the inner tube 204. Vertical portions of the nozzles 410, 420, and 430 are installed in a preliminary chamber 201a with a channel shape (groove shape), which is formed to protrude radially outward from the inner tube 204 and extend in a vertical direction. Further, the vertical portions of the nozzles 410, 420, and 430 are installed in the preliminary chamber 201a so as to extend upward (upward in the arrangement direction of the wafers 200) along an inner wall of the inner tube 204.

The nozzles 410, 420, and 430 are installed so as to extend from a lower region to an upper region of the process chamber 201. A plurality of gas supply holes 410a, 420a, and 430a are formed at positions of the nozzles 410, 420, and 430 facing the wafers 200, respectively. Thus, processing gases are supplied to the wafers 200 from the gas supply holes 410a, 420a, and 430a of the nozzles 410, 420, and 430, respectively. The plurality of gas supply holes 410a, 420a, and 430a are formed from the bottom to the top of the inner tube 204. Further, the gas supply holes 410a, 420a, and 430a are each formed with the same opening area. Furthermore, the gas supply holes 410a, 420a, and 430a are arranged at the same pitch. However, the gas supply holes 410a, 420a, and 430a are not limited to the above-described form. For example, the opening area of the gas supply holes 410a, 420a, and 430a may be gradually increased from the bottom to the top of the inner tube 204. This makes it possible to further uniformize the flow rates of gases supplied to the wafers 200 from the gas supply holes 410a, 420a, and 430a.

The gas supply holes 410a, 420a, and 430a of the nozzles 410, 420, and 430 are formed from the bottom to the top of the boat 217. Therefore, the processing gases supplied into the process chamber 201 from the gas supply holes 410a, 420a, and 430a of the nozzles 410, 420, and 430 are supplied to the entire region of the wafers 200 accommodated from the bottom to the top of the boat 217. The nozzles 410, 420, and 430 may be installed so as to extend from the lower region to the upper region of the process chamber 201, but may be desirably installed so as to extend to the vicinity of a ceiling of the boat 217.

A raw material as the processing gas is supplied into the process chamber 201 via the MFC 312, the valve 314, and the nozzle 410 from the gas supply pipe 310. Further, in the present disclosure, the raw material is also referred to as a raw material agent, a source, or a precursor.

A reaction substance as the processing gas is supplied into the process chamber 201 via the MFC 322, the valve 324, and the nozzle 420 from the gas supply pipe 320. In addition, in the present disclosure, the reaction substance is also referred to as a reaction agent or a reactant.

A modifying agent as the processing gas, which inhibits adsorption of an element contained in the precursor, unlike the reactant, is supplied into the process chamber 201 via the MFC 332, the valve 334, and the nozzle 430 from the gas supply pipe 330. In addition, in the present disclosure, the modifying agent is also referred to as a regulating agent, an adsorption inhibiting agent, a reaction inhibiting agent, or a surface regulating agent.

In the present disclosure, the term "agent" as used herein includes at least one selected from the group of a gaseous substance and a liquid substance. The liquid substance includes a mist-like substance. In other words, the modifying agent may include a gaseous substance, may include a liquid substance such as a mist-like substance, or may include both of them. Further, when the modifying agent includes a gaseous substance, it may be referred to as a precursor gas, a reaction gas, or a modifying gas.

An inert gas, for example, a nitrogen (N₂) gas is supplied into the process chamber 201 via the MFCs 512, 522, and 532, the valves 514, 524, and 534, and the nozzles 410, 420, and 430 from the gas supply pipes 510, 520, and 530. Hereinafter, an example in which a N₂ gas is used as the inert gas will be described, but, in addition to the N₂ gas, a rare gas such as an argon (Ar) gas, helium gas, neon gas, or xenon gas may also be used as the inert gas.

When supplying the precursor from the gas supply pipe 310, a precursor supply system (a first gas supply system) is mainly constituted by the gas supply pipe 310, the MFC 312, and the valve 314, but the nozzle 410 may also be considered as being included in the precursor supply system. Further, when supplying the reactant from the gas supply pipe 320, a reactant supply system (a third gas supply system) is mainly constituted by the gas supply pipe 320, the MFC 322, and the valve 324, but the nozzle 420 may also be considered as being included in the reactant supply system. Further, when supplying the modifying agent from the gas supply pipe 330, a modifying agent supply system (a second gas supply system) is mainly constituted by the gas supply pipe 330, the MFC 332, and the valve 334, but the nozzle 430 may also be considered as being included in the modifying agent supply system. Further, the precursor supply system, the reactant supply system, and the modifying agent supply system may also be referred to as a processing gas supply system. Further, the nozzles 410, 420, and 430 may be considered as being included in the processing gas supply system. Further, an inert gas supply system is mainly constituted by the gas supply pipes 510, 520, and 530, the MFCs 512, 522, and 532, and the valves 514, 524, and 534.

In addition, at the gas supply pipe 310, a reservoir 701 configured to store the processing gas and a valve 702 on the downstream side of the reservoir 701 (on the side of the process chamber 201) may be installed.

In the embodiments of the present disclosure, the gases are conveyed into the inner tube 204 via the nozzles 410, 420, and 430, which are arranged in the preliminary chamber 201a in a vertically elongated annular space defined by the inner wall of the inner tube 204 and the ends of a plurality of wafers 200. Then, the gases are ejected into the inner tube 204 from the plurality of gas supply holes 410a, 420a, and 430a installed at positions of the nozzles 410, 420, and 430 facing the wafers 200. More specifically, the precursor and the like are ejected, in a direction parallel to surfaces of the wafers 200, from the gas supply holes 410a of the nozzle 410, the gas supply holes 420a of the nozzle 420, and the gas supply holes 430a of the nozzle 430.

An exhaust hole (exhaust port) 204a is a through-hole formed in a sidewall of the inner tube 204 at a position facing the nozzles 410, 420, and 430 and is, for example, a slit-shaped through-hole elongated in a vertical direction. The gases, which were supplied into the process chamber 201 from the gas supply holes 410a, 420a, and 430a of the nozzles 410, 420, and 430 and flowed over the surfaces of the wafers 200, flow through a gap (in an exhaust path 206) formed between the inner tube 204 and the outer tube 203 via the exhaust hole 204a. Then, the gases that flowed through the exhaust path 206 flow through an exhaust pipe 231 and are discharged to the outside of the process furnace 202.

The exhaust hole 204a is formed at a position facing the plurality of wafers 200. The gases supplied from the gas supply holes 410a, 420a, and 430a to the vicinity of the wafers 200 in the process chamber 201 flow in a horizontal direction and then flow through the exhaust path 206 via the exhaust hole 204a. The exhaust hole 204a is not limited to being constituted as a slit-shaped through-hole, and may be constituted by a plurality of holes.

The exhaust pipe 231 configured to exhaust an internal atmosphere of the process chamber 201 is connected to an exhaust port 231a installed at the manifold 209. A pressure sensor 245, which serves as a pressure detector (pressure detection part) configured to detect an internal pressure of the process chamber 201, an auto pressure controller (APC) valve 243, and a vacuum pump 246 serving as a vacuum exhauster are sequentially connected, from the upstream side, to the exhaust pipe 231. The APC valve 243 may perform or stop vacuum exhaust of an interior of the process chamber 201 by being opened or closed while the vacuum pump 246 is in operation. Further, the APC valve 243 may regulating the internal pressure of the process chamber 201 by adjusting a degree of valve opening while the vacuum pump 246 is in operation. An exhaust system is mainly constituted by the exhaust hole 204a, the exhaust path 206, the exhaust pipe 231, the APC valve 243, and the pressure sensor 245. The vacuum pump 246 may also be considered as being included in the exhaust system.

A seal cap 219, which serves as a furnace opening lid configured to be capable of hermetically sealing a lower end opening of the manifold 209, is installed under the manifold 209. The seal cap 219 is configured to contact the lower end of the manifold 209 from a lower side in a vertical direction. The seal cap 219 is made of, for example, a metal such as SUS, and is formed in a disc shape. An O-ring 220b, which is a seal making contact with the lower end of the manifold 209, is installed on an upper surface of the seal cap 219. A rotator 267 configured to rotate the boat 217 accommodating the wafers 200 is installed on the side of the seal cap 219 opposite to the process chamber 201. A rotating shaft 255 of the rotator 267 passes through the seal cap 219 and is connected to the boat 217. The rotator 267 is configured to rotate the wafers 200 by rotating the boat 217. The seal cap 219 is configured to be vertically raised or lowered by a boat elevator 115, which serves as an elevator installed vertically outside the outer tube 203. The boat elevator 115 is configured to raise or lower the seal cap 219, thereby enabling loading or unloading of the boat 217 into or out of the process chamber 201. The boat elevator 115 is constituted as a transfer apparatus (transfer mechanism or transfer system) configured to transfer the boat 217 and the wafers 200 accommodated in the boat 217 into or out of the process chamber 201.

The boat 217 is configured to arrange the plurality of wafers 200, for example, 25 to 200 wafers 200 in such a state that the wafers 200 are arranged in a horizontal posture and spaced apart from each other in a vertical direction with the centers of the wafers 200 aligned with one another. The boat 217 is made of, for example, a heat-resistant material such as quartz or SiC. Dummy substrates 218, which are made of a heat-resistant material such as quartz or SiC, for example, are supported in a horizontal posture and in multiple stages at a lower side of the boat 217. According to this configuration, heat from the heater 207 is less likely to be transmitted to the seal cap 219 side. However, the embodiments of the present disclosure are not limited to the above-described form. For example, instead of providing the dummy substrates 218 at the lower side of the boat 217, a thermal insulating cylinder, which is formed as a cylindrical member made of a heat-resistant material such as quartz or SiC, may be installed.

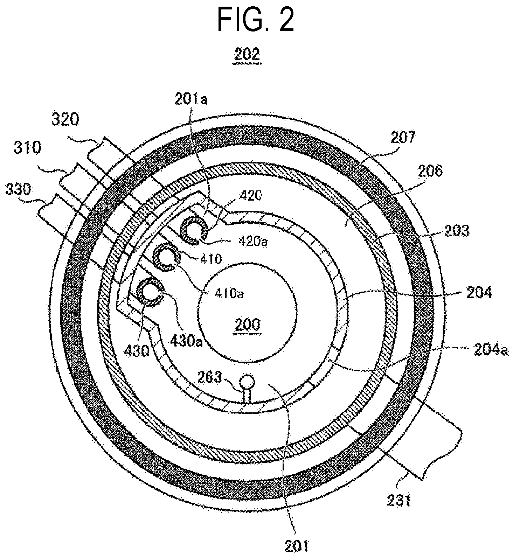

As illustrated in FIG. 2, a temperature sensor 263 serving as a temperature detector is installed inside the inner tube 204. The substrate processing apparatus 10 is configured to regulate a state of supplying electric power to the heater 207 based on temperature information detected by the temperature sensor 263, such that a temperature distribution inside the process chamber 201 becomes a desired temperature distribution. The temperature sensor 263 is configured in an L shape, similarly to the nozzles 410, 420, and 430, and is installed along the inner wall of the inner tube 204.

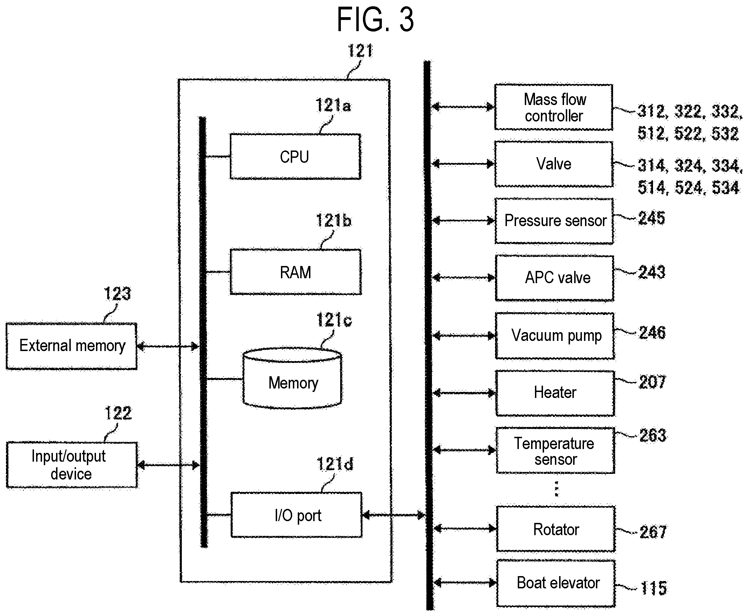

As shown in FIG. 3, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are connected to be capable of exchanging data with the CPU 121a via an internal bus 121e. An input/output device 122 including, e.g., a touch panel or the like, is connected to the controller 121. Further, the substrate processing apparatus may be configured to include one controller, or may be configured to include a plurality of controllers. That is, control to perform a processing sequence to be described later may be performed by using one controller, or may be performed by using a plurality of controllers. Further, the plurality of controller may be constituted as a control system in which the plurality of controllers are connected to each other via a wired or wireless communication network, and the entire control system may perform control to perform the processing sequence to be described later. When the term "controller" is used in the present disclosure, it may include one controller, a plurality of controllers, or a control system constituted by a plurality of controllers.

The memory 121c is constituted by, for example, a flash memory, a hard disk drive (HDD), or the like. A control program to control operations of a substrate processing apparatus, a process recipe in which sequences and conditions of a method of manufacturing a semiconductor device (a method of processing a substrate) to be described later are written, etc. are readably recorded and stored in the memory 121c. The process recipe functions as a program combined to cause the controller 121 to execute each process (each step) in the method of manufacturing the semiconductor device (the method of processing the substrate), which will be described later, so as to obtain an expected result. Hereinafter, the process recipe and the control program may be generally and simply referred to as a "program." When the term "program" is used herein, it may indicate a case of including the process recipe, a case of including the control program, or a case of including combination of the process recipe and the control program. The RAM 121b is constituted as a memory area in which programs or data read by the CPU 121a are temporarily stored.

The I/O port 121d is connected to, for example, the MFCs 312, 322, 332, 512, 522, and 532, the valves 314, 324, 334, 514, 524, 534, and 702, the pressure sensor 245, the APC valve 243, the vacuum pump 246, the heater 207, the temperature sensor 263, the rotator 267, and the boat elevator 115 described above.

The CPU 121a is configured to read and execute the control program from the memory 121c and is also configured to read the process recipe and the like from the memory 121c according to an operation command input from the input/output device 122, and the like. The CPU 121a is configured to be capable of controlling, for example, the operations of regulating flow rates of various gases by the MFCs 312, 322, 332, 512, 522, and 532, the operations of opening or closing the valves 314, 324, 334, 514, 524, 534, and 702, the operation of storing a gas into the reservoir 701 by the valve 702, the operation of opening or closing the APC valve 243, the pressure regulating operation based on the pressure sensor 245 by the APC valve 243, the temperature regulating operation of the heater 207 based on the temperature sensor 263, the operation of actuating or stopping the vacuum pump 246, the operations of rotating the boat 217 and adjusting a rotational speed of the boat 217 by the rotator 267, the operation of raising or lowering the boat 217 by the boat elevator 115, the operation of accommodating the wafers 200 in the boat 217, and so on, according to contents of the read process recipe.

The controller 121 may be constituted by installing, on the computer, the aforementioned program recorded and stored in an external memory (for example, a magnetic disk such as a hard disk, an optical disc such as a CD or DVD, or a semiconductor memory such as a USB memory or a memory card) 123. The memory 121c and the external memory 123 are constituted as computer-readable recording media. Hereinafter, these are generally and simply referred to as a recording medium. The recording medium as used herein may include the memory 121c, the external memory 123, or both the memory 121c and the external memory 123. The program (a program product) may be provided to the computer by using communication means or unit such as the Internet or a dedicated line, instead of using the external memory 123.

### (2) Substrate Processing Process

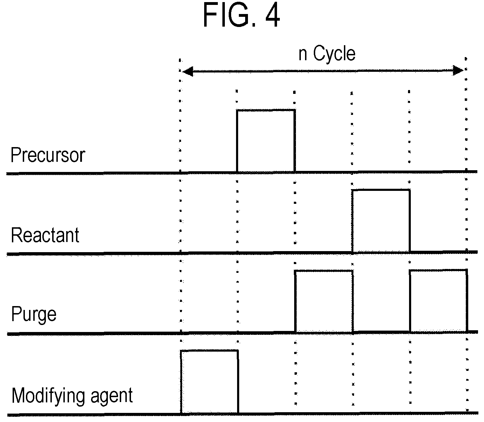

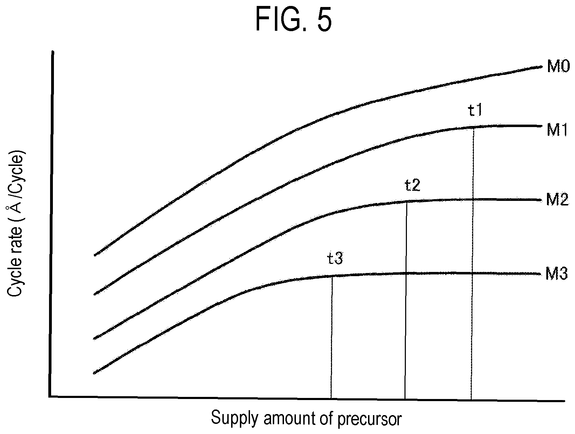

As a step of a process of manufacturing a semiconductor device, an example of a processing sequence to form a silicon nitride (SiN) film used, for example, as a charge trap film of a 3D NAND on the wafer 200 as a substrate will be described mainly with reference to FIGS. 4 and 5. The above-described example of processing sequence is executed by using the process furnace 202 of the substrate processing apparatus 10 described above. In addition, in the embodiments of the present disclosure, an example will be described in which a silicon substrate (silicon wafer) with recesses such as trenches or holes formed on a surface thereof is used as the wafer 200. In the following description, operations of the respective components constituting the substrate processing apparatus 10 are controlled by the controller 121.

A processing sequence according to the embodiments of the present disclosure includes:
(a) step A of setting a supply amount of a modifying agent based on a relationship between the supply amount of the modifying agent and a saturated adsorption property of a precursor on the wafer 200; and
(b) step B of supplying the modifying agent to the wafer 200 based on the set supply amount.

In the embodiments of the present disclosure, an example will be described in which the processing sequence further includes:
(c) step C of supplying the precursor to the wafer 200 after step B is performed; and
(d) step D of supplying a reactant to the wafer 200 after step C is performed.

When the term "wafer" is used in the present disclosure, it may refer to "a wafer itself" or "a stacked body of a wafer and a certain layer or film formed on a surface of the wafer." When the phrase "a surface of a wafer" is used in the present disclosure, it may refer to "a surface of a wafer itself" or "a surface of a certain layer or a film formed on a wafer." When the term "substrate" is used in the present disclosure, it may be synonymous with the term "wafer.".

### (Wafer Loading)

When the boat 217 is charged with a plurality of wafers 200, as illustrated in FIG. 1, the boat 217 supporting the plurality of wafers 200 is raised by the boat elevator 115 and is loaded into the process chamber 201. Then, the boat 217 supporting the plurality of wafers 200 is accommodated in the process container. In this state, the seal cap 219 closes the lower end opening of the outer tube 203 via the O-ring 220.

### (Pressure Regulation and Temperature Regulation)

An interior of the process chamber 201, that is, a space in which the wafers 200 are present is vacuum-exhausted by the vacuum pump 246, so as to reach a desired pressure (degree of vacuum). At this time, the internal pressure of the process chamber 201 is measured by the pressure sensor 245. Then, the APC valve 243 is feedback-controlled based on pressure information measured by the pressure sensor 245 (pressure regulation). The vacuum pump 246 is maintained in a constantly operated state at least until the wafers 200 are completely processed. Further, the process chamber 201 is heated by the heater 207 so that the interior of the process chamber 201 reaches a desired temperature. In this operation, a state of supplying electric power to the heater 207 is feedback-controlled based on the temperature information detected by the temperature sensor 263 such that a temperature distribution in the process chamber 201 becomes a desired temperature distribution (temperature regulation). The heating of the interior of the process chamber 201 by the heater 207 continues at least until the wafers 200 are completely processed.

### (Setting Supply Amount of Modifying Agent: Step A)

Next, a supply amount (an exposure amount) of a modifying agent is set. Here, first, the controller 121 reads, from the memory 121c, data regarding a relationship between the supply amount of a modifying agent and a saturated adsorption property of a precursor on the wafer 200. Based on that data, the supply amount of the modifying agent to be supplied to the wafer 200 in step B to be described later is set. In addition, the supply amount of the modifying agent is set based on a desired precursor cycle rate that is set in advance. This setting may be performed by an operator of the processing apparatus, or may be set from a host device (HOST), another device, or another terminal via a network. In addition, the saturated adsorption property of the precursor refers to a property regarding a change in an adsorption amount of the precursor adsorbed on the wafer 200. Specifically, when the precursor is supplied to the wafer 200, an adsorption amount of the precursor increases as a supply amount of the precursor increases until the adsorption amount of the precursor reaches a predetermined threshold, and after the adsorption amount of the precursor reaches the predetermined threshold, the adsorption amount of the precursor does not change (increase) even in a case where the supply amount of the precursor further increases. Hereinafter, this threshold is also referred to as a saturated adsorption amount. In addition, when the modifying agent is supplied before the precursor is supplied, a part of molecules of the modifying agent is adsorbed on a surface of the wafer 200, thereby reducing adsorption sites for the precursor. Thus, the saturated adsorption amount of the precursor decreases.

The above-described data is data as illustrated in FIG. 5. FIG. 5 illustrates a relationship between a supply amount of the modifying agent and an adsorption property of the precursor. In FIG. 5, a horizontal axis represents a supply amount of the precursor per cycle, and a vertical axis represents a cycle rate (a thickness of a layer formed per cycle), which substantially corresponds to an adsorption amount of the precursor adsorbed on the wafer 200 per cycle. Further, M0, M1, M2, and M3 in FIG. 5 indicate whether or not to supply the modifying agent before supplying the precursor, and also indicate a supply amount of the modifying agent when the modifying agent is supplied. M0 indicates a case where the supply amount of the modifying agent is 0 (zero), that is, a case where the modifying agent is not supplied. M1, M2, and M3 indicate the supply amounts of the modifying agent when the modifying agent is supplied, and the supply amounts of the modifying agent satisfy a relationship of M1<M2<M3. Curves illustrated in the vicinity of M0, M1, M2, and M3 indicate the adsorption property of the precursor. Specifically, the curve corresponding to M0 indicates that, as the supply amount of the precursor increases, the amount of the precursor adsorbed on the wafer 200 continues to increase, that is, the adsorption amount of the precursor does not reach saturation and remains unsaturated. The curves corresponding to M1, M2, and M3 indicate that the amount of the precursor adsorbed on the wafer 200 increases as the supply amount of the precursor increases, until the adsorption amount of the precursor reaches points t1, t2, and t3, respectively. Further, the curves corresponding to M1, M2, and M3 indicate that, when the adsorption amount of the precursor reaches points t1, t2, and t3, respectively, the adsorption amount of the precursor is saturated, and even in a case where the supply amount of the precursor further increases, the adsorption amount of the precursor does not change. That is, the curves corresponding to M1, M2, and M3 indicate the saturated adsorption property of the precursor.

Further, the curves corresponding to M1 to M3 indicate that, by increasing the supply amount of the modifying agent, it is possible to decrease an amount of the precursor to be supplied until the adsorption amount of the precursor reaches points t1 to t3 at which it is saturated. Specifically, an amount of the precursor to be supplied until the adsorption amount of the precursor reaches point t3 at which it is saturated in the curve corresponding to M3 is smaller than an amount of the precursor to be supplied until the adsorption amount of the precursor reaches point t2 at which it is saturated in the curve corresponding to M2. Further, the curves corresponding to M1 to M3 indicate that an amount of the precursor adsorbed on the wafer 200 per cycle decreases (increases) by increasing (decreasing) the supply amount of the modifying agent. In addition, in the following, points t1 to t3 at which the adsorption amount of the precursor is saturated may be referred to as saturation points t1 to t3.

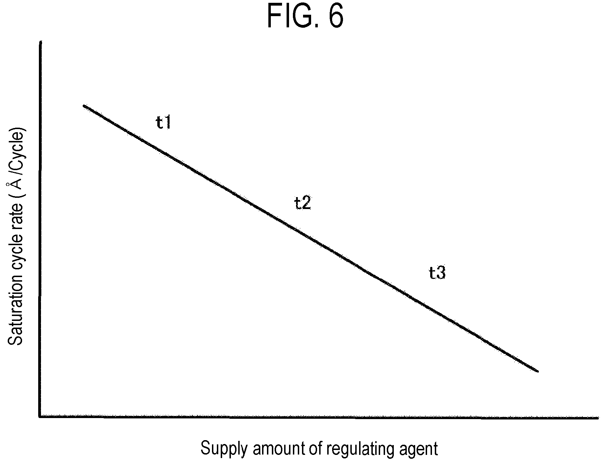

Further, FIG. 6 illustrates a relationship between a supply amount of the modifying agent and a saturated adsorption amount of the precursor. In FIG. 6, a horizontal axis represents a supply amount of the modifying agent, and a vertical axis represents a saturation cycle rate, that is, substantially, a saturated adsorption amount of the precursor per cycle. As illustrated in FIG. 6, the saturated adsorption amount of the precursor per cycle may decrease as the supply amount of the modifying agent increases.

From the above, "setting a supply amount of the modifying agent based on a relationship between the supply amount of the modifying agent and a saturated adsorption property of the precursor on the wafer 200" means, for example, that, when it is desired that a property in which the adsorption amount of the precursor is saturated at the saturation point t2 be exhibited in step C, the supply amount of the modifying agent is set to M2 based on the relationship as illustrated in FIG. 5.

The supply amount of the modifying agent set in this step may be an amount that enables the precursor to exhibit a saturated adsorption property, that is, an amount that allows the adsorption amount of the precursor on the wafer 200 to be saturable. In addition, the precursor may be supplied under a condition such that the precursor is not decomposed, or a substance that does not cause deposition of the precursor due to physical adsorption may be used as the precursor in step C to be described later, so as to reliably cause the above-described property to be exhibited.

The supply amount (exposure amount) of the modifying agent may be set by at least one selected from the group of a supply flow rate of the modifying agent, a supply time of the modifying agent, and a processing pressure (partial pressure) during supply of the modifying agent. The supply amount of the modifying agent may be set by the supply flow rate of the modifying agent and the processing pressure during supply of the modifying agent. Further, the supply amount of the modifying agent may be set by the supply flow rate of the modifying agent and the supply time of the modifying agent.

### (Modifying Agent Supply: Step B)

The controller 121 opens the valve 334 to allow the modifying agent to flow through the gas supply pipe 330. A flow rate of the modifying agent is regulated by the MFC 332 based on the flow rate setting in step A. Then, the modifying gas is supplied into the process chamber 201 from the gas supply holes 430a of the nozzle 430. The modifying agent supplied into the process chamber 201 is exhausted via the exhaust pipe 231. At this time, the modifying agent is supplied to the wafer 200. In addition, at this time, the controller 121 may open the valve 534 to allow an inert gas such as a N₂ gas to flow through the gas supply pipe 530. The N₂ gas flowing through the gas supply pipe 530 is regulated in flow rate by the MFC 532 and is then supplied into the process chamber 201 together with the modifying agent. The N₂ gas supplied into the process chamber 201 is exhausted via the exhaust pipe 231. At this time, the controller 121 may open the valves 514 and 524 to allow the N₂ gas to flow through the gas supply pipes 510 and 520, so as to prevent the modifying agent from entering the nozzles 410 and 420 . The N₂ gas is supplied into the process chamber 201 via the gas supply pipes 310 and 320 and the nozzles 410 and 420, and is exhausted via the exhaust pipe 231.

At this time, the controller 121 regulates the APC valve 243 based on the setting of the supply amount of the modifying agent set in step A, thereby setting the internal pressure (processing pressure) of the process chamber 201 to, for example, a pressure within a range of 1 to 3,990 Pa, for example, 1,000 Pa. A supply flow rate of the modifying agent that is controlled by the MFC 332 is set to, for example, a flow rate within a range of 0.005 to 5.0 slm. A supply time of the modifying agent is set to, for example, 10 to 120 seconds. Here, the controller 121 regulates the internal pressure of the process chamber 201 and the supply flow rate and supply time of the modifying agent into the process chamber 201 such that an exposure amount of the modifying agent to the wafer 200 becomes a first exposure amount. In addition, the first exposure amount in the present disclosure is obtained, for example, by a product of the partial pressure of the modifying agent in the process chamber 201 and the supply time of the modifying agent into the process chamber 201 (partial pressure×time). Further, the first exposure amount is smaller than a second exposure amount to be described later. Supply flow rates of the N₂ gas that are controlled by the MFCs 512, 522, and 532 are each set to, for example, a flow rate within a range of 0.1 to 5.0 slm. At this time, the temperature of the heater 207 is set such that the temperature of the wafer 200 is, for example, within a range of, for example, 250 to 800 degrees C, specifically within a range of 600 to 700 degrees C. In addition, notation of numerical ranges such as "1 to 3,990 Pa" in the embodiments of the present disclosure means that a lower limit value and an upper limit value are included in that range. Accordingly, for example, "1 to 3,990 Pa" means "1 Pa or more and 3,990 Pa or less." The same applies to other numerical ranges. In addition, a first supply amount (exposure amount) may be defined as a product of the supply flow rate and the supply time of the modifying agent into the process chamber 201 (supply flow rate×supply time), a product of a total pressure inside the process chamber 201 and the supply time of the modifying agent into the process chamber 201 (total pressure×supply time), or a product of the partial pressure (total pressure) inside the process chamber 201 and the supply flow rate and supply time of the modifying agent into the process chamber 201 (partial pressure (total pressure)×supply flow rate×supply time). The supply flow rate of the modifying agent into the process chamber 201 is affected by, e.g., a volume of the process container and patterns of recesses formed on the wafer 200. Therefore, the first exposure amount may be defined as a product of the partial pressure inside the process chamber 201 and the supply time of the modifying agent into the process chamber 201.

In addition, specifically, the exposure amount (first exposure amount) of the modifying agent to the wafer 200 is set to an amount at which molecules of the modifying agent are saturatedly adsorbed on an opening side of the recess (a top side of the recess) of the wafer 200 with the recesses formed on the surface thereof. In other words, specifically, the exposure amount of the modifying agent to the wafer 200 is set to an amount at which an adsorption amount of molecules of the modifying agent on the opening side of the recess (the top side of recesses) of the wafer 200 with the recesses formed on the surface thereof is saturated.

In addition, "saturation" in the present disclosure may not mean that the entirety of adsorbable sites on the wafer 200 are occupied, provided that the adsorbable sites are substantially saturated. That is, to improve productivity, the adsorbable sites may not be completely saturated, in other words, a reaction may not completely converged. For example, using incompletely saturated states on the above-described curves corresponding to M1, M2, and M3 may also be referred to as saturated adsorption in the present disclosure. At least one effect of the present disclosure may be obtained in a case where a given supply time on the above-described curves is selected. When the supply time is set within a range of the supply time that yields such curves, it may also be referred to as a supply utilizing a saturated adsorption property.

The modifying agent supplied to the wafer 200 is, for example, a halogen element-containing agent. The halogen element-containing agent is a substance containing at least one of Group 17 elements. Examples of such a substance include a hydrogen halide such as a hydrogen fluoride (HF), a hydrogen chloride (HCl), a hydrogen bromide (HBr), or a hydrogen iodide (HI). Further, the modifying agent may also be a substance composed of a halogen element such as fluorine (F₂), chlorine (Cl₂), bromine (Br₂), or iodine (I₂). Further, the modifying agent may be a substance containing two types of halogen elements, such as a nitrogen trifluoride (NF₃) or a chlorine trifluoride (ClF₃). In addition, the halogen element may include the same type of halogen element as that contained in the precursor. Specifically, a substance with high polarizability is used as the modifying agent. Examples of such a substance with high polarizability include a hydrogen halide, and specifically, HCl. Molecules of the substance with high polarizability are easily adsorbed on the wafer 200. Further, the substance with high polarizability may prevent adsorption of decomposition products (decomposition byproducts) generated by decomposition of the precursor, in addition to adsorption of the precursor itself to be described later. When adsorption on the wafer 200 is not taken into consideration, a substance such as Cl₂ may be used as the modifying agent. Although Cl₂ is lower in polarizability than a hydrogen halide, but is larger in molecular size than the hydrogen halide. Due to the large molecular size, Cl₂ exhibits the effect of inhibiting adsorption of precursor molecules and decomposition products generated by decomposition of the precursor. That is, an adsorption inhibiting substance functions as a steric hindrance. In addition, the decomposition products of the precursor may be generated on the surface of the wafer 200 or in a space above the wafer 200.

By supplying such a modifying agent to the wafer 200, an adsorption inhibiting substance is formed on the surface of the wafer 200. The adsorption inhibiting substance is a molecule containing a halogen element or the halogen element itself.

Further, by exposing (supplying) the modifying agent to the wafer 200 at the first exposure amount, molecules of the modifying agent or a part of the molecules of the modifying agent may be adsorbed on the top side of the recess formed on the surface of the wafer 200.

In addition, the modifying agent is not limited to inorganic substances described above, but may be an organic modifying agent. The organic modifying agent is, for example, a substance containing an alkyl group (alkyl ligand). The alkyl group is, for example, a methyl group. A methyl group is electrically negative and thus, repels negatively charged precursor molecules, making it difficult to bond with the precursor molecules. For example, a methyl group (Me-) and a halogen (Cl-) contained in the precursor molecules are both negatively charged and therefore are unlikely to bond with each other. Here, "Me" denotes a methyl group. That is, by adsorbing a substance containing an alkyl group on a specific location of the wafer 200 in advance, adsorption of the precursor supplied thereafter on the specific location of the wafer 200 may be prevented. In addition, examples of the substance containing an alkyl group include hexamethyldisilazane, dimethylaminotrimethylsilane, trimethylsilanol, and triethylsilanol.

After a predetermined time elapses from the start of supplying the modifying agent, for example, after 1 to 600 seconds, the controller 121 closes the valve 334 of the gas supply pipe 330 to stop the supply of the modifying agent. At this time, the controller 121 keeps the APC valve 243 of the exhaust pipe 231 open, and vacuum-exhaust the interior of the process chamber 201 by the vacuum pump 246, thereby removing the modifying agent remaining in the process chamber 201 that remains unreacted or contributed to formation of the adsorption inhibiting substance from the process chamber 201.

### (Precursor Supply: Step C)

The controller 121 opens the valve 314 to allow the precursor to flow through the gas supply pipe 310. A flow rate of the precursor is regulated by the MFC 312, and the precursor is then supplied into the process chamber 201 via the gas supply holes 410a of the nozzle 410. The precursor supplied into the process chamber 201 is exhausted via the exhaust pipe 231. Thus, the precursor is supplied to the wafer 200. At this time, the controller 121 may open the valve 514 to allow an inert gas such as a N₂ gas to flow through the gas supply pipe 510. The N₂ gas flowing through the gas supply pipe 510 is regulated in flow rate by the MFC 512, and is then supplied into the process chamber 201 together with the precursor. The N₂ gas supplied into the process chamber 201 is exhausted via the exhaust pipe 231. At this time, to prevent the precursor from entering the nozzles 420 and 430, the controller 121 may open the valves 524 and 534 to allow the N₂ gas to flow through the gas supply pipes 520 and 530. The N₂ gas is supplied into the process chamber 201 via the gas supply pipes 320 and 330 and the nozzles 420 and 430, and is then exhausted via the exhaust pipe 231.

At this time, the controller 121 regulates the APC valve 243, thereby setting the internal pressure of the process chamber 201 to, for example, a pressure within a range of 1 to 3,990 Pa, for example, 500 Pa. A supply flow rate of the precursor controlled by the MFC 312 is set to, for example, 0.1 to 5,000 sccm, specifically 10 to 1,000 sccm. A supply time of the precursor is set to, for example, 0.1 to 20 seconds. Here, the supply of the precursor to the wafer 200 may be performed under a condition in which absorption of the precursor on the wafer 200 is self-limited, or may be performed under a condition in which the adsorption is not self-limited. Performing under the condition in which adsorption of the precursor on the wafer 200 is self-limited means performing under a condition in which the adsorption amount of the precursor adsorbed on the wafer 200 is saturated. Specifically, this refers to supplying the precursor to the wafer 200 in an amount equal to or greater than a saturated adsorption amount of the precursor on the wafer 200. Further, performing under the condition in which adsorption of the precursor on the wafer 200 is not self-limited means performing under a condition in which the amount of the precursor adsorbed on the wafer 200 is unsaturated, and specifically, refers to supplying the precursor to the wafer 200 in an amount smaller than the saturated adsorption amount of the precursor on the wafer 200. A supply amount of the precursor is set to be smaller than a supply amount of the precursor when the modifying agent is not supplied in advance. As described above, by supplying the modifying agent in advance in step B, an amount of the precursor for saturation of the adsorption amount may be reduced, as compared with a case where the modifying agent is not supplied in advance. In addition, the supply amount of the precursor in the present disclosure is, for example, a product of a partial pressure of the precursor in the process chamber 201 and the supply time of the precursor into the process chamber 201 (partial pressure×time). Supply flow rates of the N₂ gas controlled by the MFCs 512, 522, and 532 are each set to, for example, flow rates within a range of 0.1 to 20.0 slm. At this time, the temperature of the heater 207 is set such that the temperature of the wafer 200 is, for example, within the range of, for example, 250 to 850 degrees C, specifically within a range of 600 to 700 degrees C. In addition, a second exposure amount in the present disclosure may be defined as a product of the supply flow rate and the supply time of the precursor into the process chamber 201 (supply flow rate×supply time), a product of a total pressure inside the process chamber 201 and the supply time of the precursor into the process chamber 201 (total pressure×supply time), or a product of the partial pressure (total pressure) in the process chamber 201 and the supply flow rate and supply time of the precursor into the process chamber 201 (partial pressure (total pressure)×supply flow rate×supply time). The supply flow rate of the precursor into the process chamber 201 is affected by, e.g., the volume of the process container and the pattern of the recess formed on the wafer 200. Therefore, the second exposure amount is desirably defined as a product of the partial pressure in the process chamber 201 and the supply time of the precursor into the process chamber 201.

In addition, in this step, by regulating the supply amount of the inert gas such as a N₂ gas supplied together with the precursor to the wafer 200, a thickness of a layer formed on the wafer 200 by performing this step may be regulated. The inert gas supplied in this step acts as a dilution gas for the precursor, and therefore, the thickness of the layer formed on the wafer 200 may be increased by decreasing the supply amount of the inert gas. Further, the thickness of the layer formed on the wafer 200 may be decreased by increasing the supply amount of the inert gas.

Further, an exposure amount (supply amount) of the gas to the wafer 200 in the present disclosure may also be said to be an adsorption amount of gas molecules adsorbed on the surface of the wafer 200. The adsorption amount may be regulated, for example, by a product of a partial pressure of the gas (modifying agent or precursor) in the process chamber 201 and a supply time of the gas (modifying agent or precursor) into the process chamber 201 (partial pressure × time), as described above.

The second exposure amount (adsorption amount) in the present disclosure may be made greater than the first exposure amount (adsorption amount) by regulating at least one selected from the group of the partial pressure, the total pressure, the supply flow rate, and the supply time relating to the second exposure amount to be greater than at least one selected from the group of the partial pressure, the total pressure, the supply flow rate, and the supply time relating to the first exposure amount.

In addition, the precursor may be stored in the reservoir 701, and the precursor may be supplied from the reservoir 701 into the process chamber 201. When the precursor stored in the reservoir 701 is supplied into the process chamber 201, the supply time of the precursor into the process chamber 201 may be shorter than the supply time of the modifying agent into the process chamber 201. In this case, for example, the exposure amounts of the precursor and the modifying agent (the first exposure amount and the second exposure amount) are regulated such that a product of the partial pressure (total pressure) of the precursor in the process chamber 201 and the supply time of the precursor into the process chamber 201 is greater than a product of the partial pressure (total pressure) of the modifying agent in the process chamber 201 and the supply time of the modifying agent into the process chamber 201. In addition, in the precursor supply step (third step), the supply of the precursor into the process chamber 201 may be performed a plurality of times as well as once. When the precursor is supplied into the process chamber 201 a plurality of times, the supply of the precursor into the process chamber 201 is stopped between a given supply and the subsequent supply. Further, when the precursor is supplied into the process chamber 201 a plurality of times, the precursor stored in the reservoir 701 may be supplied into the process chamber 201 at least once. For example, when the precursor is supplied into the process chamber 201 twice or more times, the precursor stored in the reservoir 701 is supplied into the process chamber 201 in a first supply, and the precursor is supplied into the process chamber 201 without being stored in the reservoir 701 in a second supply. In addition, the supply of the precursor into the process chamber 201 is stopped between the first supply and the second supply. Further, the interior of the process chamber 201 may be exhausted (depressurized) in conjunction with stopping the supply of the precursor into the process chamber 201, or an inert gas may be supplied into the process chamber 201 in conjunction with the exhaust. In addition, the supply and stop of the precursor into the process chamber 201 are controlled, for example, by opening or closing the valve 702.

The precursor supplied to the wafer 200 contains, for example, a main element that constitutes (is contained in) a film formed on the wafer 200. The main element is, for example, Si. As the precursor, for example, a silane-based gas containing Si may be used. The silane-based gas may be, for example, a gas containing Si and a halogen element, that is, a halosilane gas. Examples of the halogen element include chlorine (Cl), fluorine (F), bromine (Br), and iodine (I). As the halosilane gas, for example, a chlorosilane gas containing Si and Cl may be used.

As the precursor, for example, a chlorosilane gas such as a monochlorosilane (SiH₃Cl) gas, dichlorosilane (SiH₂Cl₂) gas, trichlorosilane (SiHCl₃) gas, tetrachlorosilane (SiCl₄) gas, hexachlorodisilane (Si₂Cl₆, abbreviation: HCDS) gas, or octachlorotrisilane (Si₃Cl₈) gas may be used. One or more of these may be used as the precursor. Specifically, a material containing two or more Group 14 element atoms such as Si₂Cl₆ or Si₃Cl₈ is used. The material containing two or more Group 14 element atoms may be rephrased as a material containing an A-A bond. Here, A is a Group 14 element. The A-A bond is easily broken. Therefore, such a material is likely to be decomposed.

As the precursor, in addition to the chlorosilane gas, for example, a fluorosilane gas such as tetrafluorosilane (SiF₄) gas or difluorosilane (SiH₂F₂) gas, a bromosilane gas such as tetrabromosilane (SiBr₄) gas or dibromosilane (SiH₂Br₂) gas, or an iodosilane gas such as tetraiodosilane (SiI₄) gas or diiodosilane (SiH₂I₂) gas may also be used. One or more of these may be used as the precursor.

As the precursor, in addition to these, for example, a gas containing Si and an amino group, that is, an aminosilane gas, may also be used. An amino group refers to a monovalent functional group obtained by removing a hydrogen (H) atom from ammonia, a primary amine, or a secondary amine, and may be represented by -NH₂, -NHR, or -NR₂. In addition, R represents an alkyl group, and two R groups in -NR₂ may be the same as or different from each other.

As the precursor, for example, an aminosilane gas such as tetrakis(dimethylamino)silane (Si[N(CH₃) ₂]₄) gas, tris(dimethylamino)silane (Si[N(CH₃) ₂]₃H) gas, bis(diethylamino)silane (Si[N(C₂H₅) ₂] ₂H₂) gas, bis(tert-butylamino)silane (SiH₂[NH(C₄H₉)] ₂) gas, or (diisopropylamino)silane (SiH₃[N(C₃H₇) ₂]) gas may also be used. One or more of these may be used as the precursor.

In the present disclosure, an example using a HCDS gas as the precursor will be described. When the HCDS gas is used as the precursor, a silicon (Si)-containing layer containing chlorine (Cl) may be formed as a first layer with a predetermined thickness on the outermost surface of the wafer 200. The Si-containing layer containing Cl may be formed, for example, by physical adsorption or chemical adsorption of precursor molecules on the outermost surface of the wafer 200, physical adsorption or chemical adsorption of molecules of a substance obtained by decomposition of at least a part of the precursor molecules (also referred to as decomposition products), or deposition of Si due to thermal decomposition of the precursor. In addition, the decomposition products in the present disclosure are also referred to as ligands of the precursor, or a part of the ligands of the precursor. When HCDS is used as the precursor, the decomposition products are, for example, SiClx. Here, x is 2, 3, or 4. In addition, the Si-containing layer containing Cl may be an adsorption layer (a physical adsorption layer or a chemical adsorption layer) of molecules of a chlorosilane gas or molecules of a substance obtained by partial decomposition of the chlorosilane gas, or may be a deposited layer of Si containing Cl. When the above-described chemisorption layer or the above-described deposited layer is formed on the outermost surface of the wafer 200, Si contained in the chlorosilane gas is adsorbed on the outermost surface of the wafer 200. The Si-containing layer containing Cl in the present disclosure is also simply referred to as a Si-containing layer.

Further, before the supply of the HCDS gas, a modifying agent is supplied, and an adsorption inhibiting substance is formed on the surface of the wafer 200 by the modifying agent. When a HCl gas is used as the modifying agent, an adsorption inhibiting substance such as HCl or Cl, which is a part of HCl, is formed on the surface of the wafer 200. Such an adsorption inhibiting substance inhibits adsorption of HCDS gas molecules and adsorption of SiClx. That is, due to the presence of the adsorption inhibiting substance, adsorption of at least a part of ligands of the precursor may be prevented. In addition, adsorption of SiClx with a specific value of x among SiClx may be inhibited depending on the molecular (atomic) composition of the adsorption inhibiting substance.

### (Residual Gas Removal)

After a predetermined time elapses from the start of supplying the precursor, for example, after 1 to 60 seconds, the controller 121 closes the valve 314 of the gas supply pipe 310 to stop the supply of the precursor. That is, the time for which the precursor is supplied to the wafer 200 is, for example, within a range of 1 to 60 seconds. At this time, the controller 121 keeps the APC valve 243 of the exhaust pipe 231 open, and vacuum-exhausts the interior of the process chamber 201 by the vacuum pump 246, thereby removing the precursor remaining in the process chamber 201 that remains unreacted or contributed to layer formation from the process chamber 201. That is, the controller 121 exhausts an atmosphere in the process chamber 201. At this time, the controller 121 may keep the valves 514, 524, and 534 open to maintain supply of the N₂ gas into the process chamber 201. The N₂ gas acts as a purge gas, as well as a gas for preventing intrusion of gases into the respective nozzles 410, 420, and 430. When the N₂ gas is supplied as a purge gas, the effect of removing the precursor remaining in the process chamber 201 that remains unreacted or contributed to layer formation from the process chamber 201 may be enhanced.

### (Reactant Supply: Step D)

After the residual gas in the process chamber 201 is removed, the controller 121 opens the valve 324 to allow the reactant to flow through the gas supply pipe 320. The reactant is regulated in flow rate by the MFC 322 and is then supplied into the process chamber 201 via the gas supply holes 420a of the nozzle 420. The reactant supplied into the process chamber 201 is exhausted via the exhaust pipe 231. At this time, the reactant is supplied to the wafer 200. Further, at this time, the controller 121 keeps the valves 514, 524, and 534 open to maintain supply of the N₂ gas into the gas supply pipes 510, 520, and 530. Flow rates of the N₂ gases flowing through the gas supply pipes 510, 520, and 530 are regulated by the MFCs 512, 522, and 532, respectively. The N₂ gas flowing through the gas supply pipe 520 is supplied into the process chamber 201 together with the reactant via the gas supply pipe 320 and the nozzle 420, and is then exhausted via the exhaust pipe 231. Further, the N₂ gas flowing through the gas supply pipe 530 is supplied into the process chamber 201 via the gas supply pipe 330 and the nozzle 430, and is then exhausted via the exhaust pipe 231. Thus, intrusion of the reactant into the nozzle 430 is prevented. Further, the N2 gas flowing through the gas supply pipe 510 is supplied into the process chamber 201 via the gas supply pipe 310 and the nozzle 410, and is then exhausted via the exhaust pipe 231. Thus, intrusion of the reactant into the nozzle 410 is prevented.

At this time, the controller 121 regulates the APC valve 243, thereby setting the internal pressure of the process chamber 201 to, for example, a pressure within a range of 1 to 13,300 Pa, for example, 5,000 Pa. A supply flow rate of the reactant controlled by the MFC 322 is set to, for example, a flow rate within the range of 1 to 50 slm, specifically 1 to 10 slm. A supply time of the reactant is set to, for example, 1 to 120 seconds. Supply flow rates of the N₂ gas controlled by the MFCs 512, 522, and 532 are each set to, for example, a flow rate within a range of 0.1 to 5.0 slm. In addition, the supply amount of the reactant in the present disclosure is, for example, a product of a partial pressure of the reactant in the process chamber 201 and the supply time of the reactant into the process chamber 201 (partial pressure × time). At this time, the temperature of the heater 207 is set such that the temperature of the wafer 200 is, for example, within a range of, for example, 250 to 850 degrees C, specifically within a range of 600 to 700 degrees C. In addition, the supply amount of the reactant in the present disclosure may be defined as a product of the supply flow rate and the supply time of the reactant into the process chamber 201 (supply flow rate × supply time), a product of the total pressure inside the process chamber 201 and the supply time of the reactant into the process chamber 201 (total pressure × supply time), or a product of the partial pressure (total pressure) in the process chamber 201 and the supply flow rate and supply time of the reactant into the process chamber 201 (partial pressure (total pressure) × supply flow rate × supply time). The supply flow rate of the reactant into the process chamber 201 is affected by, e.g., the volume of the process container and the pattern of the recess formed on the wafer 200. Therefore, the supply amount of the reactant may be defined as a product of the partial pressure in the process chamber 201 and the supply time of the reactant into the process chamber 201.

In addition, the supply amount (exposure amount or adsorption amount) of the reactant to the wafer 200 may be set to an amount at which the adsorption amount of reactant molecules on the wafer 200 is saturated. In other words, the supply amount of the reactant to the wafer 200 may be an amount at which the reactant molecules are saturatedly adsorbed on the wafer 200.

In addition, in this step, by regulating the supply amount of the reactant, a thickness of a layer formed on the wafer 200 by performing this step may be regulated. For example, the thickness of the layer formed on the wafer 200 by performing this step may be increased by increasing the supply amount of the reactant in this step. Further, the thickness of the layer formed on the wafer 200 by performing this step may be decreased by decreasing the supply amount of the reactant in this step.

As the reactant supplied to the wafer 200, for example, a nitrogen (N)- and hydrogen (H)-containing gas, which is a nitriding gas (nitriding agent), may be used. The N- and H-containing gas is both a N-containing gas and a H-containing gas. The N- and H-containing gas may contain N-H bonds.

As the reactant, for example, a hydrogen nitride-based gas such as an ammonia (NH₃) gas, diazen (N₂H₂) gas, hydrazine (N₂H₄) gas, or N₃H₈ gas may be used. One or more of these may be used as the reactant. In addition, when the reactant contains hydrogen, the reactant may be referred to as a reducing agent. Further, when the reducing agent is a gas, it may also be referred to as a reducing gas.

As the reactant, in addition to these, for example, a nitrogen (N)-, carbon (C)-, and hydrogen (H)-containing gas may also be used. As the N-, C-, and H-containing gas, for example, an amine-based gas or an organic hydrazine-based gas may be used. The N-, C-, and H-containing gas is a N-containing gas, a C-containing gas, a H-containing gas, and is also a N-and C-containing gas.

As the reactant, for example, an ethylamine-based gas such as a monoethylamine (C₂H₅NH₂) gas, diethylamine ((C₂H₅) ₂NH) gas, or triethylamine ((C₂H₅)₃N) gas, a methylaminebased gas such as monomethylamine (CH₃NH₂) gas, dimethylamine ((CH₃) ₂NH) gas, or trimethylamine ((CH₃)₃N) gas, or an organic hydrazine-based gas such as a monomethylhydrazine ((CH₃)HN₂H₂) gas, dimethylhydrazine ((CH₃) ₂N₂H₂) gas, or trimethylhydrazine ((CH₃) ₂N₂(CH₃)H) gas may be used. One or more of these may be used as the reactant. In addition, these gases are also referred to as amine-based gases.

### (Residual Gas Removal)

After a predetermined time elapses from the start of supplying the reactant, for example, after 1 to 1,200 seconds, the controller 121 closes the valve 324 of the gas supply pipe 320 to stop the supply of the reactant. Then, by a processing procedure similar to that of the above-described second step, the reactant and reaction by-products remaining in the process chamber 201 that remains unreacted or contributed to layer formation are removed from the process chamber 201. That is, the controller 121 exhausts an internal atmosphere of the process chamber 201.

### (Performing Predetermined Number of Times)

By performing a cycle in which the above-described step A, step B, step C, and step D are sequentially performed at least once (a predetermined number of times (n times, where n is 1 or an integer of 2 or more)), a film of an element contained in the precursor with a predetermined thickness is formed on the wafer 200. For example, a silicon nitride film (SiN film) may be formed on the wafer 200. The above-described cycle may be performed a plurality of times.

### (Purge and Returning to Atmospheric Pressure)

The controller 121 supplies a N₂ gas from each of the gas supply pipes 510, 520, and 530 into the process chamber 201. The N₂ gas supplied into the process chamber 201 is exhausted via the exhaust pipe 231. The N₂ gas acts as a purge gas. Thus, the interior of the process chamber 201 is purged with the inert gas, and the gas and reaction by-products remaining in the process chamber 201 are removed from the interior of the process chamber 201. Thereafter, the internal atmosphere of the process chamber 201 is replaced with the inert gas, and the internal pressure of the process chamber 201 is returned to normal pressure (atmospheric pressure).

### (Wafer Unloading)

Thereafter, the seal cap 219 is lowered by the boat elevator 115 to open the lower end of the outer tube 203. Then, the processed wafer 200 is unloaded from the lower end of the outer tube 203 to the outside of the outer tube 203 while being supported by the boat 217. Thereafter, the processed wafer 200 is discharged from the boat 217.

### (3) Effects of Present Embodiment

According to the embodiments of the present disclosure, one or more of effects described below may be obtained.
(a) By performing steps A and B before performing step C, the precursor may be more easily saturatedly absorbed on the wafer 200 in step C. Thus, since the adsorption amount of the precursor becomes uniform within the wafer surface, an in-plane film thickness uniformity of the wafer may be improved. Further, as a result, since film qualities such as a film density may be made uniform within the wafer surface, a wafer in-plane refractive index of the film may be made uniform.

By performing steps A and B, a desired cycle rate (substantially, an amount of the precursor adsorbed on the wafer 200 per cycle) may be obtained in the subsequent step C. For example, supplying the modifying agent in step B may reduce the cycle rate in step C, resulting in improved step coverage and gap-filling characteristics.

By supplying the modifying agent to the wafer 200 in step B, excessive adsorption of the precursor on a specific location of the wafer 200 may be prevented. Therefore, an increase in the film thickness at the specific location of the wafer 200 may be prevented, and the film thickness at another location of the wafer 200 may be increased. Further, molecules of the precursor that would otherwise be adsorbed on the specific location of the wafer 200 may be made to reach another location. In other words, consumption of the precursor at the specific location of the wafer 200 may be decreased, while consumption of the precursor at another location of the wafer 200 may be increased. Here, the specific location is, for example, a location of the wafer 200 that is close to the nozzle, or a top side of recesses in a case where the recess is formed on the wafer 200. When the specific location is the location of the wafer 200 that is close to the nozzle, the in-plane film thickness uniformity of the wafer 200 as a film characteristic may be improved. When the specific location is the top side of the recess, the adsorption amount (consumption amount) of the precursor on the top side of recesses may be decreased, and the adsorption amount (consumption amount) of the precursor on a bottom side of the recess may increase. As a result, film thickness uniformity of a film formed on the sidewall and bottom inside the recess in a depth direction of the recess may be improved. That is, step coverage as a film characteristic may be improved. Here, the recess is a trench or a hole. Further, the hole may include a blind hole or a through-hole.

(b) By performing steps A and B in advance, even in a case where a precursor that is liable to decompose in a gas phase, such as a precursor containing two or more Group 14 elements, is used in step C, the uniformity of the film formed on the wafer 200, particularly, the step coverage of the recess, may be improved. The precursor that is liable to decompose in the gas phase is, for example, a chlorosilane-based gas, and specifically includes a HCDS gas. In a case where the HCDS is used, decomposition of HCDS generates decomposition products such as, for example, SiCl₂ and SiCl₄. Among these, SiCl₂ causes a CVD reaction. When the CVD reaction occurs, a relationship between a supply time of the precursor to the wafer 200 and an increase in the film thickness (film thickness per cycle) of the wafer 200 does not exhibit a saturation relationship. That is, an unsaturation property is obtained. In addition, the unsaturation property means a property in which the film thickness (film thickness per cycle) of the wafer 200 does not converge to a predetermined value even in a case where the supply time of the precursor to the wafer 200 increases. In a case where a film is formed on the wafer 200 under a condition in which such an unsaturation property is obtained, the film thickness at a specific location of the wafer 200 increases, which may deteriorate the film thickness uniformity of the wafer 200. For the characteristics of the film formed in the recess, the step coverage may be deteriorated. According to the embodiments of the present disclosure, by supplying the modifying agent to the wafer 200 in step B, adsorption of an intermediate that causes the unsaturation property, such as SiCl₂, on the wafer 200 may be improved. As a result, the film thickness uniformity of the wafer 200 may be improved. Further, in a case where the wafer 200 with the recesses is processed, the step coverage of the film formed in the recess may be improved. Among these decomposition products, an amount of SiCl₂ generated is proportional to the supply time of the HCDS gas to the wafer 200. That is, as the supply time of the HCDS gas to the wafer 200 increases, the amount of SiCl₂ generated increases. This increase in the amount of SiCl₂ generated is attributable to an increase in a residence time of HCDS molecules in the process chamber 201 as the supply time of HCDS to the wafer 200 increases. In other words, it is conceivable that, as the residence time of HCDS molecules in the process chamber 201 increases, the time for which HCDS molecules are heated in the process chamber 201 becomes longer, thereby increasing the number of molecules that undergo thermal decomposition. the supply time of the HCDS gas to the wafer 200 may be decreased so as to decrease the amount of SiCl₂ generated and the amount of SiCl₂ adsorbed on the wafer 200. The HCDS gas to the wafer 200 may be instantaneously supplied (or flash-supplied) by using the reservoir 701 so as to decrease the supply time of the HCDS gas to the wafer 200.

(c) By setting the supply amount of the modifying agent in step A to an amount that enables the precursor to exhibit a saturated adsorption property on the wafer 200, the above-described effects may be reliably obtained.

(d) By regulating the supply amount of the modifying agent, the curve corresponding to the supply amount of the modifying agent (the curve indicating the saturated adsorption property of the precursor, *see* FIG. 5) may be regulated. For example, by increasing (decreasing) the supply amount of the modifying agent, the above-described curve may be changed to decrease (increasing) the supply amount of the precursor used until the adsorption amount of the precursor to reach saturation. The supply time of the precursor may be shortened. That is, the processing time of the wafer 200 may be shortened, resulting in an improvement in the manufacturing throughput of semiconductor devices.

(e) In step A, the supply amount of the modifying agent is set by at least one selected from the group of the supply flow rate of the modifying agent, the supply time of the modifying agent, and the processing pressure during supply of the modifying agent. Specifically, for example, the supply amount of the modifying agent is set by the supply flow rate of the modifying agent and the processing pressure during supply of the modifying agent, or by the supply flow rate of the modifying agent and the supply time of the modifying agent. By setting the supply amount of the modifying agent in this manner, the above-described effects may be reliably obtained.

(f) By using an inorganic modifying agent containing a halogen element, an increase in the amount of impurities in a film formed on the wafer 200 that are attributable to the modifying agent may be reduced. Here, the impurities refer to elements other than a main element constituting the film formed on the wafer 200. Meanwhile, a molecular size of an organic modifying agent is larger than that of an inorganic modifying agent. Therefore, in a case where the organic modifying agent is used as the modifying agent, an effect of the modifying agent acting as a steric hindrance that inhibits adsorption of the precursor on the wafer 200 is greater than that in a case where the inorganic modifying agent is used as the modifying agent.

(g) In step C, by performing the step under a condition in which adsorption of the precursor on the wafer 200 is self-limited, the above-described effect may be reliably obtained. Further, in the present disclosure, since steps A and B are performed before step C is performed, the amount of the precursor for saturating the adsorption amount may be reduced as compared with a case where steps A and B are not performed.

(h) In step C, even in a case where the step is performed under a condition in which adsorption of the precursor on the wafer 200 is not self-limited, at least some of the above-described effects may be obtained. Further, by performing the step under a condition in which adsorption of the precursor on the wafer 200 is self-limited, the thickness of the layer formed on the wafer 200 may be reduced (made thinner), thereby further improving step coverage and gap-filling characteristics.

(i) In step C, by supplying the inert gas together with the precursor and regulating the supply amount of the inert gas, the thickness of the layer formed on the wafer 200 by performing step C may be regulated. In this way, in step C, the thickness of the layer formed on the wafer 200 may be regulated by the supply amount of the inert gas supplied together with the precursor (as well as by the supply amount of the precursor). The inert gas supplied in this step acts as a dilution gas for the precursor, and therefore, the thickness of the layer formed on the wafer 200 by performing step C may be increased by decreasing the supply amount of the inert gas. Further, the thickness of the layer formed on the wafer 200 by performing step C may be reduced by increasing the supply amount of the inert gas.

(j) The above-described effects may be obtained even in a case where the precursor contains a main element contained in a film formed on the wafer 200 and a halogen element.

(k) The above-described effects may also be obtained in a case where the modifying agent contains a halogen element, and also in a case where both the precursor and the modifying agent contain the halogen element.

(l) In step D, by regulating the supply amount of the reactant, the thickness of the layer formed on the wafer 200 by performing step D may be regulated. For example, by increasing the supply amount of the reactant, the thickness of the layer formed on the wafer 200 by performing step D may be increased. Further, the thickness of the layer formed on the wafer 200 by performing step D may be reduced by decreasing the supply amount of the reactant.

In addition, like the above-described effects, the modifying agent prevents adsorption of molecules of the precursor on the wafer 200, and promotes desorption of the reactant from the wafer 200. In other words, the modifying agent modifies a surface state of the wafer 200. Therefore, the modifying agent used herein may also referred to as a post-processing gas, a posttreatment gas, a treatment gas, a modifying gas, or a desorption promoting gas. Further, the modifying agent supplied during the supply of the precursor in the present disclosure may also be referred to as a pre-processing gas, a pretreatment gas, a treatment gas, or a modifying gas, since it changes the surface state (surface property or adsorption property) of the wafer 200.

### <Other Embodiments of Present Disclosure>

The embodiments of the present disclosure are specifically described above. However, the present disclosure is not limited to the above-described embodiments, and various modifications may be made without departing from the gist of the present disclosure.

For example, in the above-described embodiments, a case in which a gas containing a Si element is used as the precursor is described as an example, but the present disclosure is not limited thereto. For example, the present disclosure may also be applied to a processing in which a gas containing at least one selected from the group of Group 13 element, Group 14 element, Group 4 element, Group 6 element, and Group 8 element is used as the precursor. In these embodiments as well, effects similar to those in the above-described embodiments are obtained.

Further, in the above-described embodiments, a case in which a gas containing a nitrogen element is used as the reactant is described as an example, but the present disclosure is not limited thereto. For example, an oxide film may be formed on the wafer 200 by using, as a reactant, a gas containing an oxygen element. Examples of the oxygen-containing gas include an oxygen (O₂) gas, water (H₂O), hydrogen peroxide (H₂O₂) gas, nitrous oxide (dinitrogen monoxide) (N₂O) gas, nitric oxide (NO) gas, and ozone (O₃) gas. Further, as the reactant, one or more of these gases may be used in an activated or excited state. In the embodiments as well, effects similar to those in the above-described embodiment are obtained.

Further, as the reactant, a gas containing a hydrogen element may be used to form, on the wafer 200, a film in which the above-described element is a main component. Examples of the hydrogen element-containing gas include, for example, a gas composed of a hydrogen element such as a hydrogen (H₂) gas or a deuterium gas, and a mononuclear parent hydride gas such as a silane-based gas, a borane-based gas, a phosphine-based gas, or a germane-based gas. Further, as the reactant, one or more of these gases may be used in an activated or excited state. Further, examples of the silane-based gas include a monosilane (SiH₄) gas, a disilane (Si₂H₆) gas, and a trisilane (Si₃H₈) gas. Examples of the borane-based gas include a monoborane (BH₃) gas and a diborane (B₂H₆) gas. Examples of the phosphine-based gas include a phosphine (PH₃) gas and a diphosphine (P₂H₆) gas. Examples of the germane-based gas include a monogermane (GeH₄) gas, a digerman (Ge₂H₆) gas, and a trigerman (Ge₃H₈) gas. In these embodiments as well, effects similar to those in the above-described embodiments are obtained.

Further, in the above-described embodiments, an example in which the reactant is supplied from the gas supply pipe 320 and the nozzle 420 is described. However, the present disclosure is not limited thereto, and the reactant may also be supplied from the gas supply pipe 330 and nozzle 430 in addition to the gas supply pipe 320 and nozzle 420. To enable such supply, for example, a configuration may be employed in which a connection pipe 703 connecting the gas supply pipe 320 and the gas supply pipe 330 is installed, and a valve 704 is installed at the connection pipe 703. In a case where the reactant is supplied from both the gas supply pipe 330 and the gas supply pipe 320, the valve 334 is closed and the valve 704 is opened. In addition, in this configuration, the reactant is supplied from both sides of the gas supply pipe 310 and the nozzle 410 configured to supply the precursor. By employing such a configuration, the supply amount of the reactant may be made uniform across the plane of the wafer 200. As a result, the in-plane film thickness uniformity of the film formed on the wafer 200 may be improved. Further, film thickness uniformity within a plurality of recesses formed on the wafer 200 may also be improved.

Further, in the above-described embodiments, an example in which the modifying agent is supplied from the gas supply pipe 330 and the nozzle 430 is described. However, the present disclosure is not limited thereto, and the modifying agent may also be supplied from the gas supply pipe 320 and nozzle 420 in addition to the gas supply pipe 330 and nozzle 430. To enable such supply, for example, a configuration may be employed in which the connection pipe 703 connecting the gas supply pipe 320 and the gas supply pipe 330 is installed, and the valve 704 is installed at the connection pipe 703. In a case where the modifying agent is supplied from both the gas supply pipe 330 and the gas supply pipe 320, the valve 324 is closed and the valve 704 is opened. In addition, in this configuration, the modifying agent is supplied from both sides of the gas supply pipe 310 and the nozzle 410 configured to supply the precursor. By employing such a configuration, the supply amount of the modifying agent may be made uniform across the plane of the wafer 200. As a result, the in-plane film thickness uniformity of the film formed on the wafer 200 may be improved. Further, film thickness uniformity within a plurality of recesses formed on the wafer 200 may also be improved.

Further, in the above-described embodiments, an example is described in which a film is formed by using a substrate processing apparatus as a batch-type vertical apparatus configured to process a plurality of substrates at once. However, the present disclosure is not limited thereto, and may also be suitably applied to a case in which a film is formed by using a single-wafer-type substrate processing apparatus configured to process one or several substrates at once. Further, in the above-described embodiments, an example of forming a film by using a substrate processing apparatus including a hot-wall-type process furnace is described. The present disclosure is not limited to the above-described embodiments, and may also be suitably applied when a film is formed by using a substrate processing apparatus including a cold-wall-type process furnace. Even in a case where these substrate processing apparatuses are used, film formation may be performed under the same sequence and processing condition as in the above-described embodiments.

In addition, in the above-described embodiments, an example is described in which the above-described processing sequence is performed in the same process chamber of the same processing apparatus (in-situ). The present disclosure is not limited to the above-described embodiments, and for example, one step and another step of the above-described processing sequence may be performed respectively in different process chambers of different processing apparatuses (ex-situ).

Process recipes (programs describing, e.g., the processing sequences and processing conditions) used when forming these various thin films may be individually provided (or a plurality of process recipes may be provided) according to the contents of substrate processing (such as a type, a composition ratio, film quality, a film thickness, a processing sequence, or a processing condition and the like of a thin film to be formed). Then, at the start of substrate processing, an appropriate process recipe may be appropriately selected from among the plurality of process recipes according to the contents of substrate processing. Specifically, the plurality of process recipes provided individually according to the content of substrate processing may be stored (installed) in advance in the memory 121c included in the substrate processing apparatus via a telecommunication line or a recording medium (external memory 123) storing the process recipes. Then, at the start of substrate processing, the CPU 121a included in the substrate processing apparatus may appropriately select an appropriate process recipe from among the plurality of process recipes recorded and stored in the memory 121c according to the contents of substrate processing. According to such a configuration, various thin films with various film types, composition ratios, film qualities, and film thicknesses may be formed in a versatile and reproducible manner with a single substrate processing apparatus. Further, the operator's operational burden (such as the burden of inputting processing procedures and processing conditions) may be reduced, thereby enabling a substrate processing to be started promptly while avoiding operational errors by the operator.

Further, the present disclosure may also be realized, for example, by changing the process recipe of an existing substrate processing apparatus. When changing the process recipe, it is also possible to install the process recipe of the present disclosure into the existing substrate processing apparatus via a communication line or a recording medium storing the process recipe, or to change the process recipe itself into the process recipe of the present disclosure by operating an input/output device of the existing substrate processing apparatus.

Further, the above-described embodiments and modifications may be used in combination as appropriate. The processing procedures and processing conditions in these cases may be, for example, the same as the processing procedures and processing conditions of the above-described embodiments and modifications.

The embodiments of the present disclosure are specifically described. However, the present disclosure is not limited to the above-described embodiments, and various modifications may be made without departing from the gist of the present disclosure.

### EXPLANATION OF REFERENCE NUMERALS

200: Wafer (substrate)

## Claims

1. A method of processing a substrate, comprising:
(a) setting a supply amount of a modifying agent based on a relationship between the supply amount of the modifying agent and a saturated adsorption property of a precursor on the substrate; and
(b) supplying the modifying agent to the substrate based on the set supply amount.

2. The method of Claim 1, wherein the supply amount set in (a) is an amount that enables the precursor to exhibit the saturated adsorption property on the substrate.

3. The method of Claim 2, wherein in (a), the supply amount is set by at least one selected from the group of a supply flow rate of the modifying agent, a supply time of the modifying agent, and a processing pressure during the supply of the modifying agent.

4. The method of Claim 2, wherein in (a), the supply amount is set by a supply flow rate of the modifying agent and a processing pressure during the supply of the modifying agent.

5. The method of Claim 1, wherein in (a), the supply amount is set by a supply flow rate of the modifying agent and a supply time of the modifying agent.

6. The method of Claim 1, further comprising (c) supplying the precursor to the substrate.

7. The method of Claim 6, wherein (c) is performed under a condition in which adsorption of the precursor on the substrate is self-limited.

8. The method of Claim 6, wherein (c) is performed under a condition in which adsorption of the precursor on the substrate is not self-limited.

9. The method of Claim 6, wherein in (c), an inert gas is supplied together with the precursor, and a thickness of a layer formed on the substrate by performing (c) is regulated by regulating a supply amount of the inert gas.

10. The method of Claim 9, wherein in (c), the thickness of the layer formed on the substrate by performing (c) is increased by decreasing the supply amount of the inert gas.

11. The method of Claim 9, wherein in (c), the thickness of the layer formed on the substrate by performing (c) is decreased by increasing the supply amount of the inert gas.

12. The method of Claim 6, further comprising (d) supplying a reactant to the substrate,
wherein in (d), a thickness of a layer formed on the substrate by performing (d) is increased by increasing a supply amount of the reactant.

13. The method of Claim 6, further comprising (d) supplying a reactant to the substrate,
wherein in (d), a thickness of a layer formed on the substrate by performing (d) is decreased by decreasing a supply amount of the reactant.

14. The method of Claim 1, wherein the precursor contains a main element contained in a film formed on the substrate and a halogen element.

15. The method of Claim 1, wherein each molecule of the precursor contains two or more atoms of a Group 14 element.

16. The method of Claim 1, wherein the modifying agent contains a halogen element.

17. The method of Claim 1, wherein both of the precursor and the modifying agent contain a halogen element.

18. A method of manufacturing a semiconductor device, comprising:
(a) setting a supply amount of a modifying agent based on a relationship between the supply amount of the modifying agent and a saturated adsorption property of a precursor on the substrate; and
(b) supplying the modifying agent to the substrate based on the set supply amount.

19. A program that causes, by a computer, a substrate processing apparatus to perform a process comprising:
(a) setting a supply amount of a modifying agent based on a relationship between the supply amount of the modifying agent and a saturated adsorption property of a precursor on a substrate; and
(b) supplying the modifying agent to the substrate based on the set supply amount.

20. A substrate processing apparatus comprising:
a modifying agent supply system configured to supply a modifying agent to a substrate; and
a controller configured to be capable of controlling the modifying agent supply system so as to perform a process including: (a) setting a supply amount of the modifying agent based on a relationship between the supply amount of the modifying agent and a saturated adsorption property of a precursor on the substrate; and (b) supplying the modifying agent to the substrate based on the set supply amount.
